# EUROPEAN PATENT APPLICATION

(11) **EP 4 033 634 A1**
(43) Date of publication of application: **27.07.2022**
(21) Application number: 21218081.4
(22) Date of filing: 29.12.2021
(51) Int. Cl.: H02J 7/00, G06F 8/65

(54) **POWER STORAGE DEVICE AND ELECTRONIC EQUIPMENT**

(30) Priority: 26.01.2021 JP 2021010301
(71) Applicant: FDK Corporation, Tokyo 108-8212 (JP)
(72) Inventor: KABASAWA, Takashi, Tokyo, 108-8212 (JP); KONDA, Naoaki, Tokyo, 108-8212 (JP); KUSAGAYA, Yusuke, Tokyo, 108-8212 (JP)
(74) Representative: Epping - Hermann - Fischer

(57) **Abstract**

A transmission/reception path PA is configured to transmit a detection result sent from a sensor 22 to a control device 23 and external equipment 3 connected to a connection terminal Ts1, and transmit a program for update transmitted from the external equipment to the control device via the connection terminal, and the control device can further perform update for updating a control program stored in a storage unit to the program for update transmitted from the external equipment via the connection terminal and the transmission/reception path.

## Description

### BACKGROUND OF THE INVENTION

### Field of the Invention

The present invention relates to a power storage device and electronic equipment.

### Description of the Related Art

In recent years, as shown in JP 2007-026712 A described below, a microprocessor to be mounted in electronic equipment has a storage unit capable of storing a control program, and is adapted to control the operation of the electronic equipment by executing the control program. Further, after the microprocessor is completed as a product, the microprocessor is enabled to update a control program stored in the storage unit due to corrections of calculation, control contents, and the like.

Conventionally, updating of the control program has been performed by disassembling electronic equipment to expose a connector used for updating the control program to the outside and further connecting external equipment for updating the control program to a circuit board via the connector. Although the frequency of performing an updating work on a control program as described above is low, it needs a labor to disassemble electronic equipment every time, so that there is a demand to avoid the dissembling work as much as possible. Therefore, the update of the control program can be performed during maintenance of the electronic equipment or the like, but this case causes a problem that the update timing is limited.

Further, for example, as shown in JP 2007-026712 A, it is conceivable to install a connector for updating in electronic equipment in order to save the labor of disassembling the electronic equipment. However, there is a problem that the number of pins of the connector increases and thus it is impossible to achieve miniaturization of electronic equipment.

### SUMMARY OF THE INVENTION

The present invention has been made to solve at least a part of the above-mentioned problem, and can be attained according to the following aspect.

A first aspect of a power storage device and electronic equipment according to an embodiment comprises: a battery; a sensor configured to detect a condition of the battery; a control device that includes a storage unit for storing a control program, and is configured to at least receive a detection result related to the condition of the battery sent from the sensor and monitor the condition of the battery by executing the control program; a connection terminal that is electrically connectable to external equipment; and a transmission/reception path for electrically connecting the sensor, the control device, and the connection terminal. The transmission/reception path is configured to transmit the detection result sent from the sensor to the control device and the external equipment connected to the connection terminal, and transmit a program for update transmitted from the external equipment to the control device via the connection terminal, and the control device can further perform update for updating a control program stored in the storage unit to a program for update transmitted from the external equipment via the connection terminal and the transmission/reception path.

A second aspect is characterized by further comprising a switch in the above-mentioned first aspect, wherein the control device determines whether there is an instruction for performing update on the control program, based on a trigger which is a direct or indirect user's operation on the switch, the control device turns off the sensor when it is determined that there is an instruction for performing update on the control program, the control device sends a notice of update permission indicating update permission of the control program to the external equipment via the transmission/reception path and the connection terminal after the sensor is turned off, and the control device in response to the notice of update permission, performs the update by using a program for update transmitted from the external equipment via the connection terminal and the transmission/reception path.

A third aspect is characterized in that in the above-mentioned second aspect, the control device further comprises a processing unit that executes computing necessary for an operation of each of components constituting the power storage device and transmits a control signal for controlling the operation of each of the components to each of the components, an input unit for receiving the detection result, and a communication unit for enabling communication with the external equipment; the input unit and the communication unit include a terminal that is electrically connected to the sensor and the connection terminal via the transmission/reception path, an electrical path for electrically connecting the processing unit and the storage unit to the terminal, and a switching element which is provided in the electric path and connects or disconnects the electric path according to a control signal transmitted from the processing unit; when the control device receives a detection result sent from the sensor, the processing unit transmits the control signal to each of the input unit and the communication unit so as to connect an electric path of the input unit by a switching element of the input unit, and disconnect an electric path of the communication unit by a switching element of the communication unit; and when the control device communicates with the external equipment, the processing unit transmits the control signal to each of the input unit and the communication unit so as to disconnect the electric path of the input unit by the switching element of the input unit and connect the electric path of the communication unit by the switching element of the communication unit.

A fourth aspect is characterized in that in any one of the first to third aspects, the battery is a secondary battery, and the control program is a program for controlling charging and discharging of the secondary battery, and inputting the detection result to monitor a condition of the secondary battery.

Electronic equipment according to a fifth aspect is characterized by comprising the power storage device according to any one of the first to fourth aspects, and an operating device that is provided as the external equipment and supplied with power from the battery to operate.

### BRIEF DESCRIPTION OF THE DRAWINGS

FIG. 1 is a circuit diagram showing a power storage device according to an embodiment and electronic equipment including the power storage device;
FIG. 2 is a flowchart showing a flow of performing update on a control program in the power storage device according to the present embodiment; and
FIG. 3 is a circuit diagram showing a power storage device according to the present embodiment when an updating device is connected, and electronic equipment including the power storage device.

### DETAILED DESCRIPTION OF THE INVENTION

Hereinafter, a power storage device and electronic equipment according to an embodiment of the present invention will be described with reference to the drawings. It should be noted that the present embodiment is not limited to the contents described below, and can be arbitrarily modified and implemented without changing the gist thereof. In addition, the drawings used for describing the embodiment are all schematically showing constituent members, and are partially emphasized, enlarged, reduced, or omitted in order to deepen the understanding, and they may not accurately represent the scales, shapes, etc. of the constituent members.

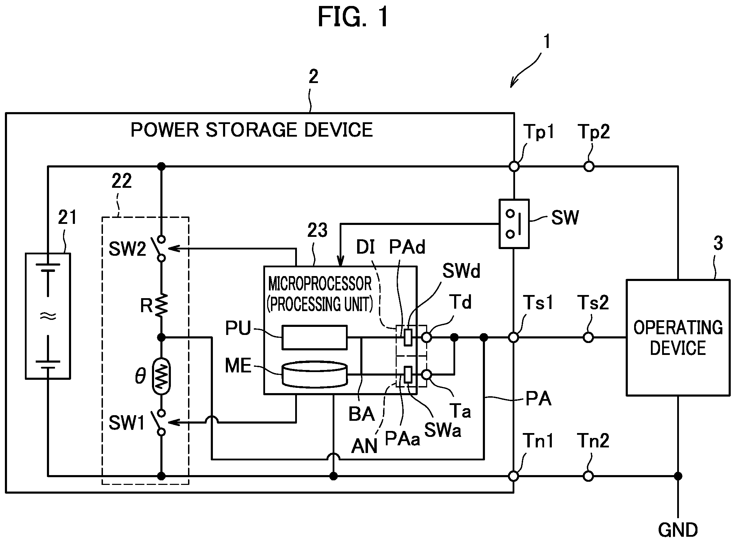

FIG. 1 is a circuit diagram showing a power storage device 2 according to the present embodiment and electronic equipment 1 including the power storage device 2. The electronic equipment 1 according to the present embodiment is a device for receiving power from a built-in battery 21 and executes a predetermined operation. The electronic equipment 1 includes the power storage device 2 and an operating device (external equipment) 3. A positive electrode end (positive electrode side terminal) Tp1 of the power storage device 2 is connected to a positive electrode end (positive electrode side terminal) Tp2 of the operating device 3. Further, a negative electrode end (negative electrode side terminal) Tn1 of the power storage device 2 is connected to a negative electrode end (negative electrode side terminal) Tn2 of the operating device 3. Still further, the negative electrode end Tn1 and the negative electrode end Tn2 are connected to a ground GND (that is, the power storage device 2 and the operating device 3 are grounded). The power storage device 2 in the present embodiment supplies electric power from the built-in battery 21 in the power storage device 2 to the operating device 3 via the positive electrode end Tp1 and the positive electrode end Tp2. Further, the operating device 3 in the present embodiment receives electric power supplied from the battery 21 and executes a predetermined operation.

Here, the battery 21 in the present embodiment is a generally known primary battery such as a manganese battery, an alkaline battery and a lithium battery, or a generally known secondary battery such as a nickel hydrogen battery and a lithium ion battery. Further, the battery 21 may be a single battery or a battery pack. The operating device 3 in the present embodiment is, for example, a generally known device such as an electric tool and an electric moving body. The electric moving body is a mobility scooter, an electric golf cart, or the like.

The power storage device 2 according to the present embodiment has a sensor 22, a microprocessor (processing unit) 23, and a switch SW in addition to the battery 21. The sensor 22 is configured to detect the condition of the battery 21. For example, the sensor 22 detects changes in the temperature, current, voltage, pressure, etc. of the battery 21, and outputs analog voltages according to the changes in the temperature, current, voltage, pressure, etc. of the battery 21 as the detection result. Here, the sensor 22 shown in FIG. 1 includes a series circuit in which a resistor R and a thermistor θ are connected in series, and is connected in parallel in association with the battery 21. The thermistor θ is an electronic component whose resistance value changes with a change in temperature. That is, the sensor 22 shown in FIG. 1 detects the temperature change of the battery 21 by the change of the resistance value of the thermistor θ, and outputs an analog voltage corresponding to the temperature change of the battery 21 (a voltage divided by the resistance R and the thermistor θ) as the detection result.

Further, the sensor 22 is provided with a switch SW1 on the negative electrode side of the series circuit, and a switch SW2 on the positive electrode side of the series circuit, and the switch SW1 and the switch SW2 are turned on or off under the control of the microprocessor 23 as described later (in other words, according to a control signal transmitted from a processing unit PU of the microprocessor 23 described later). For example, during normal operation (when power is supplied from the power storage device 2 to the operating device 3), the switch SW1 and the switch SW2 are turned on under the control of the microprocessor 23. Further, when update is performed as described later, the switch SW1 and the switch SW2 are turned off under the control of the microprocessor 23.

The power storage device 2 includes a connection terminal Ts1 which is provided separately from the positive electrode end Tp1 and the negative electrode end Tn1, is electrically connectable to a connection terminal Ts2 provided in the operating device 3, and functions as a connection terminal on the power storage device side. Further, the power storage device 2 has a transmission/reception path PA that electrically connects the sensor 22, the microprocessor 23, and the connection end Ts1.

Specifically, the transmission/reception path PA is connected to an electric path for connecting the resistor R of the sensor 22 and the thermistor θ. Further, the transmission/reception path PA is configured to transmit the detection result (analog voltage) sent from the sensor 22 to the microprocessor 23 and the operating device (external equipment) 3 connected to the connection end Ts1. Further, the transmission/reception path PA is configured to transmit a program for update transmitted from the operating device (external equipment) 3 to the microprocessor 23 via the connection end Ts1. That is, in the power storage device 2 and the electronic equipment 1 according to the present embodiment, a path through which the detection result sent from the sensor 22 is output to the external equipment, and a path used to execute communication for updating the control program stored in a memory ME of the microprocessor 23 are not provided separately from each other, but the paths are shared.

The microprocessor 23 includes a processor, a memory, and the like as hardware resources. For example, the microprocessor 23 in the present embodiment includes a processing unit PU, a memory ME, an input unit AN, and a communication unit DI. The processing unit PU, the memory ME, the input unit AN, and the communication unit DI are electrically and mutually connected to one another via a bus BA provided in the microprocessor 23. The processing unit PU executes computing necessary for the operation of each of components constituting the power storage device 2, and transmits a control signal for controlling the operation of each of the devices to each of the devices. The memory ME functions as a storage unit for storing the control program. The input unit AN is provided at least for receiving the above-mentioned detection result. The communication unit DI is provided to at least enable communication with the external equipment to be performed.

The microprocessor 23 is configured to control each of the components constituting the power storage device 2 through the processing unit PU by executing the control program. For example, the microprocessor 23 is configured to at least receive the detection result sent from the sensor 22 and monitor the condition of the battery 21 through the processing unit PU by executing the control program. Specifically, when the battery 21 is a secondary battery, the microprocessor 23 controls the charging/discharging of the battery 21 and receiving the detection result to monitor the condition of the battery 21 through the processing unit PU by executing the control program. Further, the microprocessor 23 turns on or off the switch SW1 and the switch SW2 provided in the sensor 22 through the processing unit PU. For example, during normal operation of the electronic equipment 1 (during power supply from the power storage device 2 to the operating device 3), the microprocessor 23 turns on the switch SW1 and the switch SW2 through the processing unit PU. Further, when update is performed as described later, the microprocessor 23 turns off the switch SW1 and the switch SW2 through the processing unit PU. That is, the microprocessor 23 stops the output of the detection result (analog voltage) from the sensor 22 by turning off the switch SW1 and the switch SW2. Note that the microprocessor 23 is connected to the ground GND (that is, the microprocessor 23 is grounded).

Here, the input unit AN has a terminal (analog terminal) Ta, an electric path PAa, and a switching element SWa. The terminal Ta is a metal piece forming a part of the electric path, and is electrically connected to the sensor 22 and the connection terminal Ts1 described later via the transmission/reception path PA. The electric path PAa is provided to electrically connect the processing unit PU and the memory ME to the terminal Ta together with the bus BA. The switching element SWa is provided in the electric path PAa, and also provided for connecting or disconnecting the electric path PAa according to a control signal transmitted from the processing unit PU. Note that the switching element SWa in the present embodiment also includes an element which is used as a constituent element of a device (for example, an A/D converter (not shown)) constituting the input unit AN.

The communication unit DI has a terminal (digital terminal) Td, an electric path PAd, and a switching element SWd. The terminal Td is a metal piece forming a part of the electric path, and is electrically connected to the sensor 22 and the connection terminal Ts1 via the transmission/reception path PA. The electric path PAd is provided to electrically connect the processing unit PU and the memory ME to the terminal Td together with the bus BA. The switching element SWd is provided in the electric path PAd, and also provided for connecting or disconnecting the electric path PAd according to a control signal transmitted from the processing unit PU.

When the microprocessor 23 receives the detection result sent from the sensor 22, the processing unit PU transmits the control signal to each of the input unit AN and the communication unit DI so as to connect the electric path PAa of the input unit AN by the switching element SWa of the input unit AN and disconnect the electric path PAd of the communication unit DI by the switching element SWd of the communication unit DI. Further, when the microprocessor 23 communicates with the operating device (external equipment) 3, the processing unit PU transmits the control signal to each of the input unit AN and the communication unit DI so as to disconnect the electric path PAa of the input unit AN by the switching element SWa of the input unit AN and connect the electric path PAd of the communication unit DI by the switching element SWd of the communication unit DI.

The switch SW accepts a direct or indirect operation from a user, which serves as a trigger for performing update described later. Note that any switch generally used for the electronic equipment 1 can be appropriately used as the switch SW in the present embodiment, and accepts a direct or indirect user's operation serving as a trigger for performing update described later according to the type of the switch SW. For example, when the switch SW in the present embodiment is a single push button switch, a user's push operation on the switch SW is accepted. The push operation is, for example, a long press.

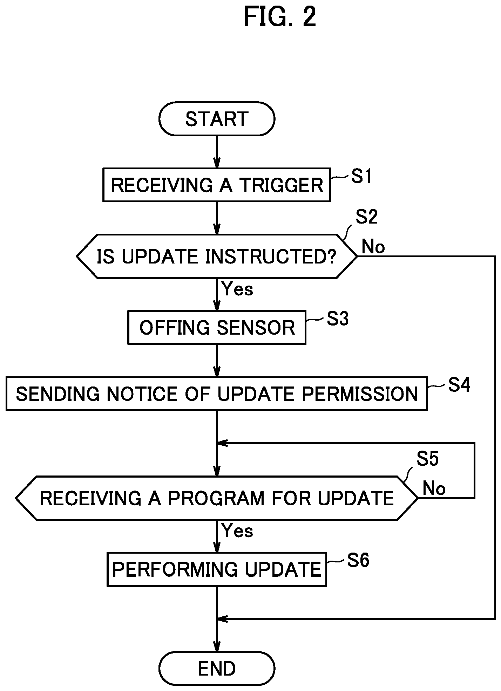

Here, in the power storage device 2 according to the present embodiment, performing update on the control program stored in the memory ME will be described with reference to FIG. 2.

FIG. 2 is a flowchart showing a flow of performing update on the control program in the power storage device 2 according to the present embodiment. Note that the flowchart shown in FIG. 2 is assumed to show a flow of performing update on the control program during normal operation of the electronic equipment 1 (during power supply from the power storage device 2 to the operating device 3) and when the switch SW accepts a direct or indirect operation from the user). That is, it is assumed that the microprocessor 23 has received the detection result sent from the sensor 22 at the start of the flowchart shown in FIG. 2. Further, it is assumed that the processing unit PU has transmitted the control signal to each of the input unit AN and the communication unit DI so as to connect the electric path PAa of the input unit AN by the switching element SWa of the input unit AN and disconnect the electric path PAd of the communication unit DI by the switching element SWd of the communication unit DI. In other words, the microprocessor 23 has been put into a state where it can sense a signal input from the input unit AN, but into a state where it cannot sense any signal input from the communication unit DI.

First, the switch SW receives a direct or indirect operation from the user as a trigger (step S1). After the end of step S1, the microprocessor 23 communicates with the operating device 3 via the transmission/reception path PA, the connection end Ts1 and the connection end Ts2, based on a trigger which is a direct or indirect user's operation on the switch SW. Note that when communicating with the operating device 3, the processing unit PU transmits the control signal to each of the input unit AN and the communication DI so as to temporarily disconnect the electric path PAa of the input unit AN by the switching element SWa of the input unit AN and also temporarily connect the electric path PAd of the communication unit DI by the switching element SWd of the communication unit DI. In other words, the microprocessor 23 has been put into a state where it cannot sense any signal input from the input unit AN, and also into a state where it can sense a signal input from the communication unit DI. The microprocessor 23 communicates with the operating device 3 to determine whether or not there is any instruction for updating the control program (step S2).

When it is determined based on the communication with the operating device 3 that there is an instruction for updating the control program (Yes in step S2), the microprocessor 23 turns off the sensor 22 by the processing unit PU (step S3). That is, the microprocessor 23 turns off the switch SW1 and the switch SW2 by the processing unit PU. At this time, the processing unit PU transmits the control signal to each of the input unit AN and the communication unit DI so as to disconnect the electric path PAa of the input unit AN by the switching element SWa of the input unit AN and connect the electric path PAd of the communication unit DI by the switching element SWd of the communication unit DI until the updating is completed.

When it is determined based on the communication with the operating device 3 that there is no instruction for updating the control program (No in step S2), it is not necessary to update the control program, so that a series of processing is ended. At this time, in order to restart the input of the detection result from the sensor 22, the processing unit PU transmits the control signal to each of the input unit AN and the communication unit DI so as to connect the electric path PAa of the input unit AN by the switching element SWa of the input unit AN and disconnect the electric path PAd of the communication unit DI by the switching element SWd of the communication unit DI.

After the end of step S3, the microprocessor 23 sends a notice of update permission indicating permission of update of the control program to the operating device 3 via the transmission/reception path PA, the connection end Ts1 and the connection end Ts2 (step S4). After the end of step S4, in response to the notice of update permission, the microprocessor 23 determines whether or not it has received a program for update transmitted from the operating device 3 via the connection end Ts2, the connection end Ts1, and the transmission/reception path PA (step S5), and repeats the processing of step S5 until it has received the program for update. When receiving the program for update (Yes in step S5), the microprocessor 23 performs updating for updating the control program stored in the memory ME to the program for update transmitted from the operating device 3 (step S6). After the end of step S6, a series of processing is ended. At this time, in order to restart the input of the detection result from the sensor 22, the processing unit PU transmits the control signal to each of the input unit AN and the communication unit DI so as to connect the electric path PAa of the input unit AN by the switching element SWa of the input unit AN, and disconnect the electric path PAd of the communication unit DI by the switching element SWd of the communication unit DI.

According to the above-mentioned configuration, in the power storage device 2 according to the present embodiment and the electronic equipment 1 including the power storage device 2, the transmission/reception path PA is configured to transmit the detection result (analog voltage) sent from the sensor 22 to the microprocessor 23 and the operating device (external equipment) 3 connected to the connection end Ts1. Further, the transmission/reception path PA is configured to transmit the program for update transmitted from the operating device (external equipment) 3 to the microprocessor 23 via the connection end Ts1. Still further, the microprocessor 23 can perform update for updating the control program stored in the memory (storage unit) ME to the program for update transmitted from the operating device (external equipment) 3 via the connection end Ts1 and the transmission/reception path PA.

In the power storage device 2 and the electronic equipment 1 according to the present embodiment, the connection end Ts1 is always exposed to the outside of the power storage device 2. That is, for the power storage device 2 and the electronic equipment 1 according to the present embodiment, it is not required to disassemble the electronic equipment 1 and expose a terminal (connector) used for updating the control program to the outside during maintenance or the like of the electronic equipment 1. Further, in the power storage device 2 and the electronic equipment 1 according to the present embodiment, the path for outputting the detection result sent from the sensor 22 to the external equipment and the path for executing communication for updating the control program stored in the memory ME of the microprocessor 23 are not provided separately from each other, but are commonized. That is, in the power storage device 2 and the electronic equipment 1 according to the present embodiment, it is possible to reduce the paths to be provided separately from each other and save the space by commonizing the paths.

Therefore, the power storage device 2 and the electronic equipment 1 according to the present embodiment can achieve miniaturization of the device and the equipment while saving the labor required for the updating work on the control program. Further, the power storage device 2 and the electronic equipment 1 according to the present embodiment can reduce the cost by commonizing paths.

The power storage device 2 and the electronic equipment 1 according to the present embodiment are provided with the switch SW. The power storage device 2 and the electronic equipment 1 according to the present embodiment perform update based on a trigger which is a direct or indirect user's operation on the switch SW. In other words, the power storage device 2 and the electronic equipment 1 according to the present embodiment do not perform update unless the switch SW is subjected to a direct or indirect operation from the user. That is, the power storage device 2 and the electronic equipment 1 according to the present embodiment can perform update at an arbitrary timing of the user.

In the power storage device 2 and the electronic equipment 1 according to the present embodiment, when the microprocessor 23 receives the detection result sent from the sensor 22, the control signal is transmitted to each of the input unit AN and the communication unit DI from the processing unit PC of the microprocessor 23 so as to connect the electric path PAa of the input unit AN by the switching element SWa of the input unit AN, and disconnect the electric path PAd of the communication unit DI by the switching element SWd of the communication unit DI. Further, in the power storage device 2 and the electronic equipment 1 according to the present embodiment, when the microprocessor 23 communicates with the operating device (external equipment) 3, the control signal is transmitted to each of the input unit AN and the communication unit DI from the processing unit PU of the microprocessor 23 so as to disconnect the electric path PAa of the input unit AN by the switching element SWa of the input unit AN and connect the electric path PAd of the communication unit DI by the switching element SWd of the communication unit DI.

That is, the power storage device 2 and the electronic equipment 1 according to the present embodiment can switch the role of the path (a role as a path for outputting a detection result sent from the sensor 22 to the external equipment and a role as a path to execute communication for updating the control program stored in the memory ME of the microprocessor 23) without providing any special path switching component (for example, a switching element) in the transmission/reception path PA. That is, the power storage device 2 and the electronic equipment 1 according to the present embodiment can reduce the number of components to be provided in the path. Further, the power storage device 2 and the electronic equipment 1 according to the present embodiment can perform cost reduction and simplification of circuits due to reduction in the number of components.

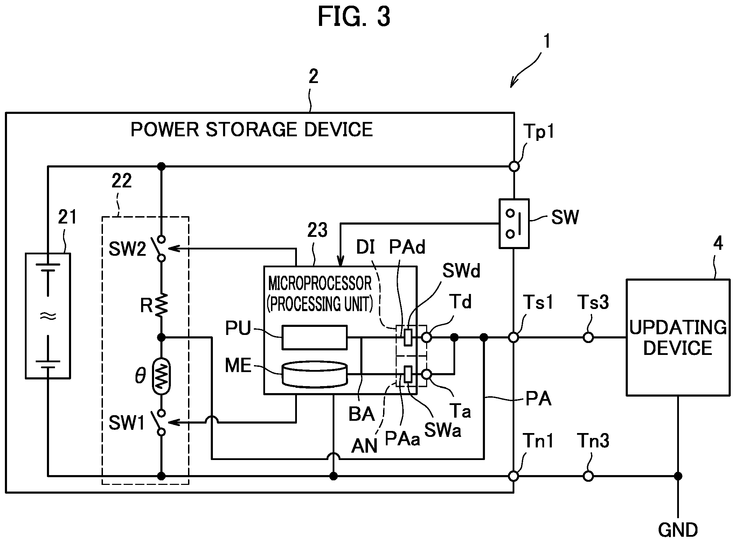

In the power storage device 2 and the electronic equipment 1 according to the present embodiment, the update program is acquired from the operating device 3. However, the power storage device 2 and the electronic equipment 1 according to the present embodiment are not limited to this mode. For example, the power storage device 2 and the electronic equipment 1 according to the present embodiment may be provided with an updating device 4 dedicated to updating as shown in FIG. 3. When performing update, the power storage device 2 and the electronic equipment 1 according to the present embodiment may connect the connection end (connection terminal) Ts3 of the updating device 4 to the connection end Ts1 to update the control program to a program for update as shown in the flowchart of FIG. 2.

In the power storage device 2 and the electronic equipment 1 according to the present embodiment, the sensor 22 including the resistor R and the thermistor θ is shown as an example, and the sensor 22 in the present embodiment is not limited to the above-mentioned configuration. For example, in the power storage device 2 and the electronic equipment 1 according to the present embodiment, any sensor 22 capable of detecting changes in the temperature, current, voltage, pressure, etc. of the battery 21 can be appropriately used.

In the power storage device 2 and the electronic equipment 1 according to the present embodiment, the trigger for performing update is not limited to the switch SW, and the update may be performed by using another component or operation as a trigger.

The "processor" used in the above description means, for example, a dedicated or general-purpose processor such as a central processing unit (CPU), a micro processing unit (MPU), or a graphics processing unit (GPU), or an application specific integrated circuit (ASIC), a programmable logic device (for example, a simple programmable logic device (SPLD), a complex programmable logic device (CPLD)), or a field programmable gate array (FPGA) or the like. Further, each component (each processing unit) of the present embodiment is not limited to a single processor, and may be implemented by a plurality of processors. Further, a plurality of components (a plurality of processing units) may be implemented by a single processor.

The "memory" used in the above description means various storage media required for the above-mentioned microprocessor such as a register or cache memory of the above-mentioned "processor", a read only memory (ROM), a main storage device (RAM (Random Access Memory)), or an auxiliary storage device such as a hard disc drive (HDD) or a solid-state drive (SSD).

The embodiment of the present invention has been described above, but the present embodiment is presented as an example and is not intended to limit the scope of the invention. This novel embodiment can be implemented in various other styles, and various omissions, replacements, and changes can be made without departing from the gist of the invention. The present embodiment and its modifications are included in the scope and gist of the invention, and are included in the scope of the invention described in the claims and the equivalent scope thereof.

## Claims

1. A power storage device comprising:
a battery;
a sensor configured to detect a condition of the battery;
a control device that includes a storage unit for storing a control program, and is configured to at least receive a detection result related to the condition of the battery sent from the sensor and monitor the condition of the battery by executing the control program;
a connection terminal that is electrically connectable to external equipment; and
a transmission/reception path for electrically connecting the sensor, the control device, and the connection terminal,
wherein the transmission/reception path is configured to transmit the detection result sent from the sensor to the control device and the external equipment connected to the connection terminal, and transmit a program for update transmitted from the external equipment to the control device via the connection terminal, and
wherein the control device can further perform update for updating a control program stored in the storage unit to a program for update transmitted from the external equipment via the connection terminal and the transmission/reception path.

2. The power storage device according to claim 1, further comprising a switch,
wherein the control device:
determines whether there is an instruction for performing update on the control program, based on a trigger which is a direct or indirect user's operation on the switch;
turns off the sensor when it is determined that there is an instruction for performing update on the control program;
sends a notice of update permission indicating update permission of the control program to the external equipment via the transmission/reception path and the connection terminal after the sensor is turned off; and
in response to the notice of update permission, performs the update by using a program for update transmitted from the external equipment via the connection terminal and the transmission/reception path.

3. The power storage device according to one of claims 1 or 2,
wherein the control device further comprises:
a processing unit that executes computing necessary for an operation of each of components constituting the power storage device and transmits a control signal for controlling the operation of each of the components to each of the components;
an input unit for receiving the detection result; and
a communication unit for enabling communication with the external equipment,
wherein the input unit and the communication unit include:
a terminal that is electrically connected to the sensor and the connection terminal via the transmission/reception path;
an electrical path for electrically connecting the processing unit and the storage unit to the terminal; and
a switching element which is provided in the electric path and connects or disconnects the electric path according to a control signal transmitted from the processing unit, and
wherein when the control device receives a detection result sent from the sensor, the processing unit transmits the control signal to each of the input unit and the communication unit so as to connect an electric path of the input unit by a switching element of the input unit, and disconnect an electric path of the communication unit by a switching element of the communication unit, and
when the control device communicates with the external equipment, the processing unit transmits the control signal to each of the input unit and the communication unit so as to disconnect the electric path of the input unit by the switching element of the input unit and connect the electric path of the communication unit by the switching element of the communication unit.

4. The power storage device according to one of claims 1 to 3,
wherein the battery is a secondary battery, and
wherein the control program is a program for controlling charging and discharging of the secondary battery, and inputting the detection result to monitor a condition of the secondary battery.

5. Electronic equipment comprising:
the power storage device according to one of claims 1 to 4; and
an operating device that is provided as the external equipment and supplied with power from the battery to operate.
